(19) Europäisches Patentamt / European Patent Office / Office européen des brevets

(11) **EP 2 071 568 A1**

(12) **EUROPEAN PATENT APPLICATION**

(43) Date of publication:
**17.06.2009 Bulletin 2009/25**

(51) Int Cl.:
*G11B 7/125* (2006.01)     *H01S 5/026* (2006.01)
*H01S 5/068* (2006.01)

(21) Application number: **07024246.6**

(22) Date of filing: **13.12.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Harman Becker Automotive Systems GmbH**
**76307 Karlsbad (DE)**

(72) Inventor: **Seegert, Bernhard**
**78050 Villingen (DE)**

(74) Representative: **Grünecker, Kinkeldey, Stockmair & Schwanhäusser Anwaltssozietät**
**Leopoldstrasse 4**
**80802 München (DE)**

(54) **Temperature sensing in an optical reproducing / recording device**

(57) The invention relates to a very precise temperature sensing function of an optical pickup in an optical reproducing/recording apparatus such as an optical disc drive with a small hardware effort. Rather than including dedicated hardware components for temperature sensing, such as PTC elements in the apparatus, a monitor diode (photodetector) employed for automatic laser power control is additionally employed as temperature sensor. Due to direct thermal coupling between laser diode and monitor diode, the operation temperature of the laser diode itself can be precisely determined. Therefore, the present invention is particularly suitable for lifetime estimation of the laser diode.

Fig. 1

**Description**

The present invention relates to optical reproducing/recording devices for optical storage media, such as optical discs, or magneto-optical discs. In particular, the present invention relates to optical reproducing/recording devices having an internal temperature setting function, and a temperature determining method performed therein.

Currently, optical storage media such as optical discs, optical and magneto-optical discs (including standard discs such as CD, CD-ROM, CD-RW, DVD, Blue-Ray-Discs, HD-DVD, and further formats still under development) have been broadly introduced and are used in a widespread field of applications. Applications include, but are not limited to, computer devices, mass storage database systems, audio and video equipment for home entertainment systems, as well as mobile applications, such as vehicle information and entertainment systems.

Recording and/or reproducing devices for optical or magneto-optical storage media generally include a moveable portion in close proximity to the storage medium including a laser diode (LD) as a light emitting device. The moveable portion including the laser diode is called an optical pickup means or simply an optical head. The laser diode is a semiconductor-based active optical element, which is generally driven (excited) by a predetermined current, in order to provide a predetermined light output, based on control information from a control circuit associated with the laser diode. The predetermined output light is irradiated onto the storage medium, to read out data recorded thereon. Another predetermined output light is irradiated onto the storage medium to record data thereon. For seek of simplicity, optical recording/reproducing apparatuses will sometimes be called "optical disk drives" or simply "disk drives" throughout this specification. It is further noted that terms like "optical reproducing/recording apparatus" and related are intended to cover devices for operating all kinds of laser-operated storage media, including magneto-optical disks.

A laser diode is generally characterized by a particular value (called threshold current $I_{th}$) of the driving current. As long as the driving current is below the threshold current $I_{th}$, the laser diode only radiates light according to spontaneous emission, in the same manner as a light emitting diode (LED). After $I_{th}$ has been reached, the laser effect (induced emission) suddenly starts, and laser light is generated. Above the threshold current, the optical output power of the laser light ($P_{out}$) increases strongly with growing driving current. Generally, a linear dependency between laser optical output power and driving current exists, until some maximum output power is reached. The driving current must not be adjusted to exceed a maximum output power specified for the laser diode, since even short-time exceeding of the maximum power will cause a deterioration of the laser diode or may even destroy it.

Laser diodes included in an optical pickup are generally driven in an automatic power control (APC) mode. Therefore, optical pickup devices generally include, together with the laser diode, a monitor diode (MD), which is a light sensitive element (photodiode). A small portion of the output light of the laser diode is deflected towards the monitor diode, in order to achieve light coupling between the laser diode and the monitor diode. Preferably, the laser diode and the monitor diode are integrated in a common housing. Due to the optical coupling, the monitor diode delivers an output voltage (monitor voltage) as a physical parameter that is proportional to the optical output power of the laser diode. The monitor voltage reflecting the optical output power is used as an input parameter for laser power control circuitry, for adjusting the driving current to achieve constant output power.

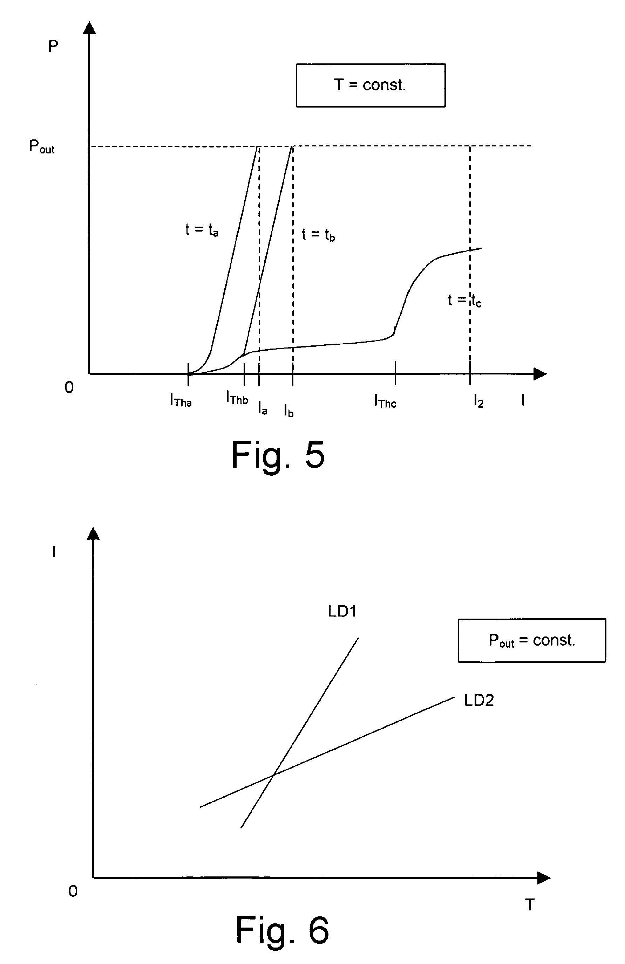

Laser diodes deteriorate with time. Deterioration of a laser diode generally leads to a decreasing intensity of the radiated light of a constantly driven laser diode. Accordingly, the driving current I required to obtain a predetermined light output Pout rises with the increasing operation time of the laser diode. While the required driving current for a predetermined output power generally tends to only slowly increase over an extended period of time, after a certain operation time has elapsed, the light output starts to drop sharply when a certain driving current is exceeded (cf. the right-most curve in Fig. 5, corresponding to a maximum operation time of $t = t_c$). The effect described is due to a chain reaction which destroys the diode, if the threshold current exceeds a certain value due to deterioration. Since the laser diode has been irreversibly destroyed at this point of operation time, it has to be considered that the lifetime of the laser diode has expired.

Laser diodes employed in contemporary disc drives have a lifetime of at least several thousands of hours of operation, as a rule. However, the lifetime achieved in a particular situation strongly depends on a plurality of factors. These factors include driving current (respectively desired output power), as well as temperature. Generally, the lifetime of a laser diode decreases with increasing driving current, and with increasing temperature.

Since deterioration of laser diodes is one of the most important reasons for the failure of disc drives, it is desirable to estimate a point of time when expiry of the lifetime of the laser diode has to be expected, as accurately as possible. However, although an average lifetime may be indicated for a certain type of laser diode as a result of statistical evaluation, individual lifetimes generally vary. Moreover, as indicated, the individual lifetime strongly depends on the operation conditions under which a particular laser diode is driven.

Therefore, by simply monitoring operation time, and replacing an optical pickup after a predefined average lifetime has expired, an optical pickup may be replaced even though it would be fully usable for a further period of time. On the other hand, a situation may arise wherein a laser diode suddenly fails, and therefore data are recorded or reproduced in an improper manner, without any indication being given to a user in this respect, in due time.

In view of the characteristic behaviour of a laser diode upon expiry of lifetime as described above, an attempt to estimate expiry of lifetime taking into account the individual situation of a laser diode can be based on monitoring the driving current for achieving a predetermined optical output power, controlled to be constant by APC. If the required driving current starts to increase considerably, it has to be considered that the lifetime of the laser diode has expired. Notification would be issued, informing the user that replacement of the optical pickup is indicated. Moreover, operation of the laser diode may be automatically stopped, in order to avoid a situation of improper recording or reading.

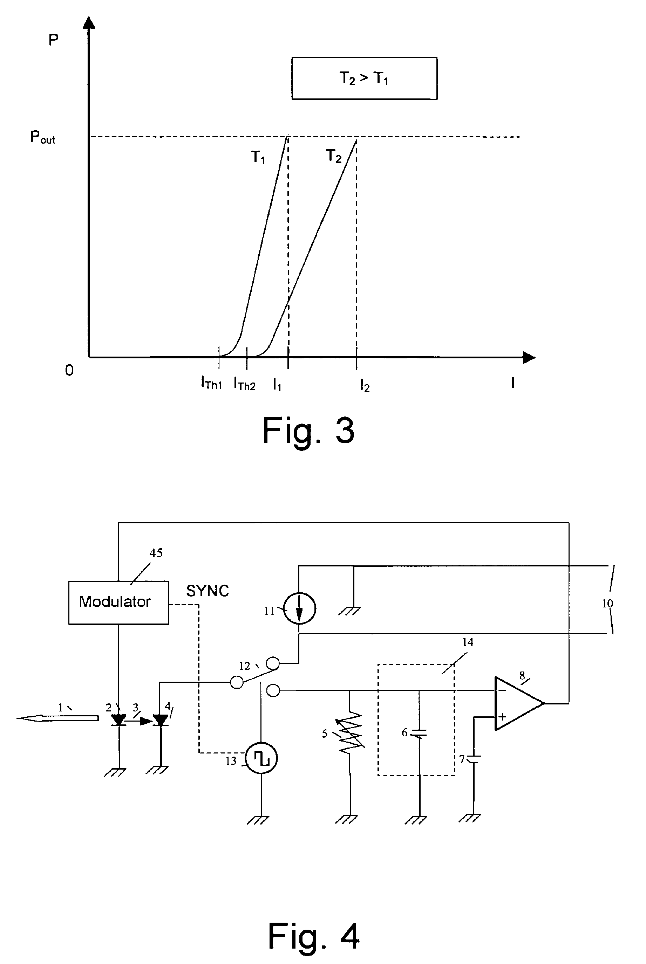

However, the amount of driving current required to achieve a certain predetermined output power (as well as the laser threshold of a diode itself) is not fixed for a given laser diode, but depends on the temperature of operating the laser diode. In this connection it is noted that the temperature of the laser diode increases due to the operation itself. As can be seen from the qualitative chart of Fig. 3, the laser threshold current value, as well as the driving current required for a predetermined level of output power will increase with increasing temperature of the laser diode. Therefore, a difficulty arises if it is desired to estimate the lifetime of a laser diode based on monitoring the driving current at a predetermined constant laser output power. Namely, an increase in driving power may occur due to an increase in temperature, as well as due to deterioration. However, by simply monitoring the driving current, the influence of temperature and the influence of deterioration cannot be properly distinguished.

In order to enable a proper estimation of laser diode lifetime, it is therefore desirable to estimate the temperature of the laser diode in an optical pickup device of an optical reproducing /recording apparatus (disc drive), together with monitoring driving current. Only when temperature changes during operation of the laser diode are taken into account, an undue increase of the driving current caused by deterioration can be clearly detected.

There may be a plurality of other reasons as to why temperature sensing would be a meaningful feature to be available in an optical disc drive. For instance, power consumption increases and lifetime decreases with increasing operation temperature. Moreover, at high operation temperatures, the failure rate also generally increases. It might therefore be desirable to enable an automatic control to temporarily stop operation of the pickup device, if a certain threshold temperature is exceeded. The feature is particularly advantageous for devices which are used under various environmental conditions, including those wherein insufficient ventilation is available.

In the case of recording apparatuses, temperature control is generally important, in order to enable proper data recording. Namely, temperature also influences the optical wavelength of light emitted by a laser diode, and the index of refraction of a material such as plastic from which an optical disc is made. Although these influences may compensate each other to a certain extent, data recording errors may occur that cannot be tolerated, if the operating temperature of a recording device increases too much. Also, power control can be improved, when taking into account operating temperature, together with the laser output power determined by the monitor diode.

Therefore, optical disc drive devices have been proposed wherein a temperature detector is provided in the vicinity of the laser diode. A temperature value sensed in the vicinity of the laser diode can be provided to a processor, together with the monitored current value of the laser diode, for estimating expiry of lifetime of the laser diode, taking into account the influence of the operation temperature. Furthermore, the processor may perform further processing functions, taking into account the measured temperature. Alternatively, a signal indicating the temperature may be directly input to the laser power control circuitry, as an additional parameter for controlling laser diode driving current.

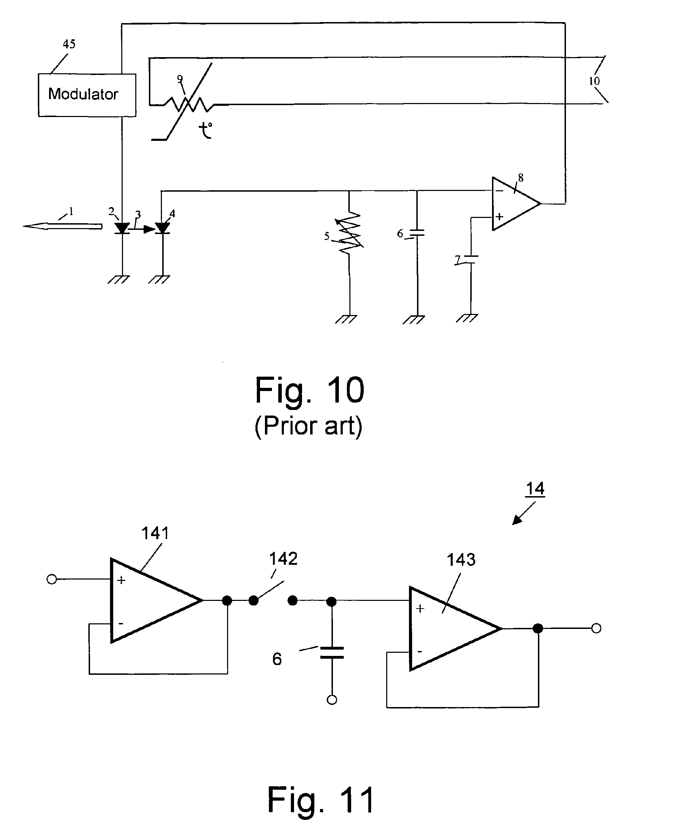

An example of a conventional optical reproducing/recording apparatus, wherein a temperature is additionally detected, is illustrated in Fig. 10. An optical pickup portion includes a laser diode 2 for providing a main laser beam 1 for disc read-out/recording. The laser diode 2 is optically coupled by a small deflected light portion 3 to a monitor diode 4. The monitor diode provides a monitor voltage to laser control circuitry. The laser control circuitry includes a potentiometer for laser power adjustment 5, a capacitor 6, and a power controller 8 for adjusting laser power comparing a control voltage based on the output of the monitor diode with a predetermined reference voltage, provided from source 7.

Optionally, a laser modulator 45 is provided for switching on and off laser diode 2 at a high frequency. Thereby, performance is improved, since Reflected Intensity Noise in the laser is reduced.

In order to determine the operation temperature, the disc drive of Fig. 10 additionally includes a temperature sensor 9 to be arranged in the vicinity of the optical pickup, and a terminal 10 for temperature measurement. As temperature sensors, preferably components such as NTC-(negative temperature coefficient) or PTC-(positive temperature coefficient) elements are used.

It is a drawback of a conventional optical reproducing/recording apparatus including a temperature sensor that there is an insufficient thermal coupling between the temperature sensing device and the heat source. Therefore, in the conventional optical disc drive, the accuracy of temperature sensing of the laser diode is rather limited.

The present invention aims to provide an optical reproducing/recording apparatus having an improved temperature determining function that enables a precise temperature measurement of the laser diode, and a temperature determining method therefor.

This is achieved by the features of the independent claims.

According to a first aspect of the present invention, an optical reproducing/recording apparatus, comprising a laser diode for providing a laser light beam for reading or recording information on an optical storage medium is provided.

The optical reproducing/recording apparatus further comprises laser control circuitry for adjusting laser power of the laser diode. Moreover, the apparatus comprises a monitor diode for sensing a light output of the laser diode and providing a monitor voltage to the laser control circuitry, as a feedback based on the sensed light output. The monitor diode is connectable for further providing a voltage indicating a temperature, based on a predetermined current flowing through the monitor diode.

According to a further aspect of the present invention, a method of determining a temperature in an optical reproducing/recording apparatus is provided. The optical reproducing/recording apparatus includes a laser diode for providing a laser light beam for reading or recording information on an optical storage medium, laser control circuitry for adjusting laser power of the laser diode, and a monitor diode for sensing the light output of the laser diode and providing a monitor voltage to the laser control circuitry, as a feedback based on the sensed light output. The method comprises the step of connecting the monitor diode for providing a voltage indicating a temperature, based on a predetermined current flowing through the monitor diode.

It is the particular approach of the present invention to employ the monitor diode of an optical disc drive, besides its generic function of providing feedback for automatic laser power control, also for a temperature sensing function. Since the monitor diode and the laser diode are generally arranged in close proximity to each other, preferably in a common cabinet, direct thermal coupling exists between the laser diode and the monitor diode used as a temperature sensing element. Accordingly, very precise determination of the temperature of the laser diode is possible. Therefore, the accuracy of estimating the lifetime of the laser diode is improved. Moreover, since a monitor diode is already included in the disc drive for automatic power control, the additional hardware effort is minimized. In particular, no separate component dedicated to temperature sensing, such as a PTC-element, is required.

The predetermined current flowing through the monitor diode is preferably a constant current. The voltage that occurs when a current flows through the pn-junction of the monitor diode is capable of indicating the temperature of the monitor diode since the temperature dependency of the current-voltage characteristic of the pn-junction is known. In particular, for a constant current, there is a unique correspondence between the voltage drop across the monitor diode, and the temperature.

For a particular monitor diode, the temperature dependency of the voltage for the predetermined current can be determined at the time of manufacture in an environment having a well-defined temperature, in order to calibrate the temperature sensing function based on the monitor diode. Preferably, a look-up table including temperature values in association with corresponding voltage values is pre-stored in a memory during the calibration process.

As a rule, the temperature dependency of the voltage is represented by a linear function over a large range of temperatures, and for a wide range of current intensities that can be practically used. A processor can therefore easily determine a precise temperature value corresponding to a voltage, even if a voltage value is provided that is not included in the look-up table, by interpolation.

According to a preferred embodiment of the present invention, the optical reproducing /recording apparatus further comprises switching means for switching the monitor diode between the monitor voltage providing function for laser power control and the temperature sensing function. During its generic monitoring function, a photo current is generated in the monitor diode, which depends on the amount of laser output light sensed. For the temperature sensing function, a predetermined current flow through the monitor diode is required. Therefore, the monitor diode cannot be employed for both functions at the same time. The switching means enables to perform the two functions of the monitor diode subsequently in time. For instance, a periodic switching between two operation modes of the monitor diode corresponding to the light sensing and the temperature sensing function can be performed, wherein a period of time for laser light detection is followed by a smaller period of time for temperature detection.

More preferably, the switching means is capable of switching a terminal of the monitor diode between a current source for providing the predetermined current and the laser control circuitry. Accordingly, during a period of time wherein the switching means connects the monitor diode to the laser control circuitry, a voltage in accordance with the generated photocurrent flowing through the monitor diode is supplied to the laser control circuitry. During a period wherein the terminal is switched to the current source, flow of the predetermined current through the monitor diode is enabled, for the temperature sensing function.

Further preferably, the temperature sensed by the monitor diode is corrected for crosstalk due to interference between the photocurrent and the predetermined current. Accordingly, a more precise temperature measurement can be performed.

Preferably, the laser control circuitry includes a laser power controller, wherein an internal reference voltage is available to be compared with a monitor voltage, a potentiometer for laser power adjustment and a capacitor. More preferably, the capacitor is capable of holding the monitor voltage during a period wherein the monitor diode is switched to the temperature sensing function. In other words, each period of time, during which the monitor diode is switched to the temperature sensing function, shall be short enough for the capacitor to hold the monitor voltage. Accordingly, laser power adjustment is continuously controlled, even during the short periods of time when the monitor diode is not available for laser power control. More preferably, a sample and hold circuit is included for loading said capacitor. The sample and hold circuit preferably includes an impedance converter, a switch, a voltage follower (buffer) and the capacitor. Accordingly, the frequency characteristic does not change when the potentiometer value is changed.

Further preferably, the reference voltage is provided in a device including the laser power controller within a large scale integration (LSI). More preferably, the LSI also includes the impedance converter, the switch and the voltage follower of the sample and hold circuit, if provided.

Preferably, the switching means comprises a multiplexer. More preferably, a pulse generator is provided for controlling the multiplexer. The multiplexer is switched to the position for connecting the monitor diode to the current source during the pulse time of a pulse generated by the pulse generator. Accordingly, short switching times can be precisely defined, which are short enough for the capacitor to hold the monitor voltage.

Preferably, the apparatus further comprises a laser modulator for switching said laser diode on and off at a high frequency (300 - 500MHz, for instance 400MHz). Thereby, Reflected Intensity Noise in the laser is reduced. More preferably, the switching means are synchronized with the laser modulation voltage provided by the laser modulator. Thereby, the monitor diode is switched to the temperature sensing function during a period, when the laser diode is switched off. Consequently, no crosstalk is possible from the laser diode to the monitor diode.

Preferably, the large scale integration including the laser power controller further includes the current source, the multiplexer and the pulse generator. Accordingly, the required hardware can be provided in a particularly compact manner.

According to a preferred embodiment, the laser diode and the monitor diode are arranged in close proximity to each other. Such an arrangement enables that the temperature sensed by the monitor diode is as close as possible to the temperature of the laser diode. More preferably, the laser diode and the monitor diode are arranged in an optical pickup device. Still more preferably, the laser diode and the monitor diode are mounted in a common cabinet. Thereby, a particularly close thermal coupling between laser and monitor diode is achieved.

Further preferably, the optical pickup device includes additional electronic components, such as laser control circuitry, switching means, current source and/or memory. Accordingly, all device specific default values and adjustment values, such as temperature coefficients, temperature correction terms, look-up table values of measured laser current and temperature etc. are physically coupled with the optical pickup device and thus automatically updated upon exchange of the optical pickup. Measured values can be transmitted to the main board, for instance via bus system. Moreover, device specific adjustment values determined upon manufacturing can be transferred to a label at the optical pickup (for instance a 2D barcode with the serial number) during manufacturing, and read into the processor on the main board by scanning. The additional effort therefor is small, since there are already conventional pickups having labels indicating serial number and laser current intensity.

Alternatively, the electronic control and memory units can be provided on the main board, which is connected to the optical pickup via a flexible connection such as a flexible board.

According to a further preferred embodiment of an optical reproducing/recording apparatus, a current detector for monitoring an intensity of an input current of the laser diode is provided. Since the laser output power is monitored independently, the input current corresponding to a particular laser light output can be determined. As outlined above, an increase of the input current is characteristic for deterioration of the laser diode.

More preferably, the apparatus therefore further includes a processor for estimating deterioration of the laser diode, based on the monitored input current intensity, and the temperature is provided by the temperature sensing function of the monitor diode. Still more preferably, the processing means compares the monitored input current intensity with a default input current intensity corresponding to the respective laser light output. The default input current intensity corresponds to an input current intensity required for the respective laser light output at the indicated temperature, at the beginning of the life cycle of the laser diode, i.e. when the laser diode is new. Since the input current intensity necessary to achieve a predetermined output power tends to increase drastically at the end of the life cycle of the laser diode, thereby the expiry of the lifetime of the laser diode can be precisely detected.

Still more preferably, the default input current intensity is stored in a memory. Since the default input current intensity corresponds to an input intensity for achieving a predetermined laser output power when the laser diode is new, most preferably the default input current intensity is stored at the time of manufacture.

Preferably, the memory stores a look-up table including default input current intensity values for a plurality of temperature values. Since the dependency between input current and temperature can be represented by a linear function in the relevant range of working temperatures of the laser diodes employed in optical pickup devices, the processor can easily determine default input current intensity values for temperature values not included into the look-up table, by performing a linear interpolation.

According to an alternative embodiment, only a single default input current intensity value is pre-stored. The single default input current intensity value accordingly corresponds to a particular default temperature. In order to take into account the temperature indicated by the temperature setting function of the monitor diode, the processor is capable of calculating a temperature correction term. A calculation formula for the temperature correction term can be determined upon manufacturing based on the linear current-temperature dependency of the new laser diode.

According to a preferred embodiment, the processor determines a temperature corrected default input current intensity by applying the calculated temperature correction term to the stored default input current intensity. Subsequently, the monitored input current intensity is compared with the temperature corrected default input current intensity.

According to an alternative preferred embodiment, the processor temperature corrects the monitored input current intensity by applying the temperature correction term to the monitored input current intensity. Subsequently, the temperature corrected value of the monitored input current intensity is compared with the stored single default input current intensity.

Further preferably, the processor determines a degree of deterioration indicating expiry of lifetime of the laser diode, if the comparison shows that the monitored input current intensity is significantly larger than the default input current intensity (in correspondence with the respective measured temperature). More preferably, the processor determines the degree of deterioration of the laser diode, if the monitored input current intensity exceeds the default input current intensity by a predetermined amount. The predetermined amount can be defined for a particular kind of a laser diode, so that it is characteristic for an excess deterioration of that particular laser diode.

Alternatively preferably, expiry of the lifetime of the laser diode is determined, if the monitored input current intensity exceeds the default input current intensity by a predetermined percentage (i.e. a predetermined factor). For instance, expiry of lifetime can be determined to be likely to occur, if the input current exceeds the corresponding default input current for the respective temperature by any predefined percentage below 50% (corresponding to a factor between 1 and 1.5), or preferably in the range from 10% to 30%, for instance 20% (corresponding to a factor from 1.1 to 1.3, for instance 1.2).

Preferably, the optical reproducing/recording apparatus further comprises notification means for issuing a notification signal, if the processor determines that expiry of lifetime of the laser diode is likely to occur. More preferably, the notification signal includes a digital signal, which can be stored in a memory. Out of the memory, the notification signal can be read out by an external device, such as a laptop of a service technician.

Further preferably, the notification signal includes an acoustic or optical warning, in order to directly inform a user that lifetime expiry of a laser diode is to be expected, and replacement of the optical pickup unit is desirable.

Further preferably, the processor is capable of automatically switching off the laser diode, when a degree of deterioration is determined that indicates expiry of lifetime, so that an error-free operation of the device is no longer likely.

According to a further preferred embodiment, the apparatus comprises an analog/digital converter for converting the voltage indicating a temperature into a digital signal. A digital signal can be forwarded by a bus system to any further external or internal processing unit, as desired. Accordingly, the temperature measured by employing the monitor diode can be used for various purposes, besides lifetime estimation as outlined in the above-mentioned embodiments.

According to a further preferred aspect of the present invention, a vehicle entertainment and information system is provided. The vehicle entertainment and information system includes an optical reproducing/recording apparatus according to the first aspect of the present invention.

Further embodiments of the present invention are the subject matter of the dependent claims.

Additional features and advantages of the present invention will become apparent from the following more particular description, as illustrated in the accompanying drawings, wherein:

Fig. 1 is a simplified general scheme illustrating the concept underlying the present invention;

Fig. 2 is a more detailed scheme of an embodiment of the present invention;

Fig. 3 is a chart illustrating the input-output characteristic of a laser diode, and the temperature dependency thereof;

Fig. 4 is an exemplary illustration for the electronic scheme of an optical reproducing/recording apparatus according to an embodiment of the present invention;

Fig. 5 is a chart illustrating the modification of the input-output characteristic of a laser diode with increasing time of operation, due to deterioration;

Fig. 6 is a chart illustrating the dependency between input current and temperature for a predetermined laser output power;

Fog. 7 is a chart illustrating how the input power required for a predetermined laser output power of a laser diode changes with increasing operation time;

Fig. 8A is a chart illustrating the temperature dependency of the current-voltage characteristic of a forward-biased pn-junction;

Fig 8B is a chart illustrating how the voltage drop caused by a constant forward current flow through a pn-junction of a diode changes with temperature;

Fig. 9 is a flowchart illustrating a method according to an embodiment of the present invention;

Fig. 10 is an electronic scheme of a conventional optical reproducing/recording apparatus having a temperature measurement function; and

Fig. 11 is a basic scheme of a sample and hold circuit included as an optional element in the embodiment of the present invention illustrated in Fig. 4.

Illustrative embodiments of the present invention will now be described with reference to the drawings.

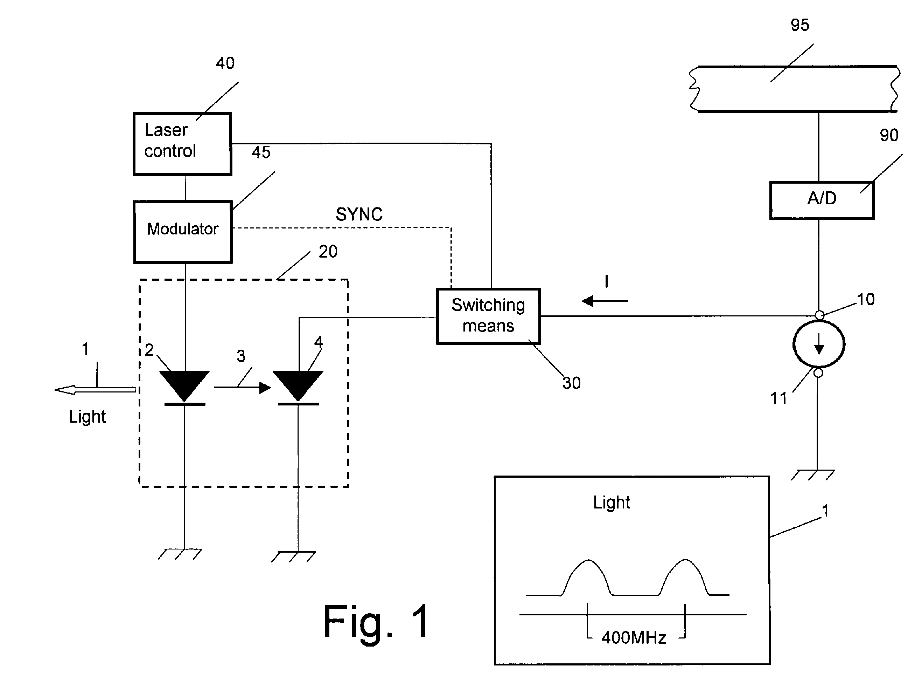

Fig. 1 is a simplified diagram illustrating the overall structure of an optical reproducing/recording apparatus (optical disc drive) according to the present invention. The core element of the apparatus is optical pickup section 20 for providing a laser light beam for reproducing or recording information on an optical storage medium, such as an optical disc. It has to be understood that terms such as "optical storage medium", "optical disc" or "optical disc drive" include various embodiments of optical storage media, such as CD, DVD, HD-DVD, Blue-Ray Discs etc., as well as magneto-optical discs such as mini-discs and apparatuses for reproducing and/or recording information thereon. The above-mentioned examples of optical storage technologies is however not limited. The present invention is applicable not only to those optical storage technologies that are widespread at the time of filing the application, but also to those that are under development or will emerge in the future, such as, for instance, 4GOOD (fourth generation omni-purpose optical disc system) and other technologies employing a laser diode.

Moreover, a person skilled in the art is aware how data recorded on an optical storage medium can be read out by analyzing modulations of the laser light beam by data structures recorded on the optical storage medium, as well as how recording is achieved by modulating the laser light beam. Since the details of the respective reading and recording processes are not essential for the present invention, a detailed description thereof and an illustration of the respective circuitry are omitted herein.

The central element of optical pickup 20 is represented by laser diode 2, which provides the main laser light beam 1 employed for data reading/recording. Generally speaking, a laser diode is an active electro-optic device that is capable of emitting light upon a current flow of a driving current through the device. The characteristic behaviour of a laser diode can be seen from the graphics illustrated in Fig. 3. As long as the intensity of the driving current does not reach a predetermined value (threshold current $I_{th}$), only low intensity light is emitted in a similar manner as in an LED light emitting diode. However, as soon as the driving current intensity exceeds $I_{th}$, the diode generates laser light. The optical output power increases rather steeply if the driving current of the diode further grows. As can be seen from Fig. 3, the dependency between output power and input current is substantially linear, up to a predetermined maximum output power specified by the manufacturer of the laser diode. The specified maximum output power must not be exceeded. If the laser diode is driven to exceed the maximum output power, it will not only be noted that the output power will no longer be further growing with increasing driving current according to the linear dependency, but also irreversible changes will occur that render the diode unusable. In a similar manner, also an unlimited increase of the driving current will lead to irreversible deterioration of the laser diode. Therefore, driving of a laser diode must be carefully controlled, as will be outlined in more detail below.

Fig. 3 further illustrates the influence on the temperature of the dependency between optical output power and input current of the laser diode. Fig. 3 shows two graphs, corresponding to different temperatures $T_1$ and $T_2$, so that temperature $T_2$ is larger than $T_1$. As can be seen from the figure, the required threshold current $I_{th}$ for starting the lasing operation increases with the temperature. On the other hand, optical output power for a given current intensity, as well as the steepness of the curve ("differential degree of efficiency") decrease with increasing temperature. It is further noted that during operation of the laser diode, the temperature generally increases, since a part of the driving energy is converted into heat, and the laser diode therefore acts as a heat source itself.

In view of the illustrated behaviour of a laser diode, driving of a laser diode must be carefully controlled. Generally, there are two possibilities of controlling driving of a laser diode: automatic current control (ACC) and automatic power control (APC). ACC aims to control the driving current to be constant. In view of the temperature dependency characteristic of a laser diode as outlined above, in addition to current control, ACC also requires precise control of the temperature. If, on the other hand, ACC would be employed without controlling the temperature to remain constant, the output power would not be constant and could even exceed the maximum output power specified by the manufacturer. The effort for ACC is therefore rather large, and it is mostly applied in high precision devices. Most applications operating under a condition of varying environmental temperature, including commercial optical pickup devices for home or industrial application, therefore rely on APC.

APC requires a parameter that is proportional to the optical output power, as feedback information. Therefore, optical pickup 20 includes monitor diode 4. Preferably, monitor diode 4 and laser diode 2 are integrated in a common cabinet. A monitor diode is a photodiode, wherein a photocurrent is generated when light is irradiated on a photosensitive area. In order to achieve optical coupling between the laser diode and the monitor diode, a small but fixed portion of the main laser light beam 1 is optically separated and directed towards a light sensitive area of the monitor diode, as indicated by arrow 3 in Fig. 1. A monitor current signal representing light power detected by the monitor diode 4 is converted to a voltage signal. Preferably, current-to-voltage conversion is performed in a potentiometer (not shown in Fig. 1). According to the principle of a photodiode, the monitor diode converts light into current. This current multiplied by the resistance of the potentiometer delivers the monitor voltage. The monitor voltage is provided to dedicated laser control circuitry 40 for adjusting laser power based on the received monitor voltage representing feedback information. A particular embodiment of laser control circuitry 40 will be described below in connection with Fig. 4.

In accordance with the present invention, a monitor diode is additionally also used for sensing a temperature within the optical pickup device. As shown in Fig. 1, an optical reproducing/recording apparatus according to an embodiment of the invention therefore further comprises a switching means 30 that enables the disconnection of an electric connection between monitor diode 4 and laser control circuitry 40, and the connection of the respective electrical connection to current source 11. Accordingly, switchover of switching means 30 from laser control circuitry 40 to current source 11 results in a predetermined current I provided by the current source to flow through monitor diode 4, in a forward direction. As a person skilled in the art is aware, current flow through the pn-junction of a diode, such as monitor diode 4 results in a voltage drop that can be detected and output at terminal 10. In view of the characteristic temperature dependency of the current-voltage characteristic of the pn-junction of a diode, which will be described in more detail below, the voltage drop provided at terminal 10 caused by the flow of a predetermined current unambiguously corresponds to a temperature, and can therefore be used as a measure for an operating temperature of the monitor diode.

It is noted that the dashed box indicating "optical pickup device" 20 is shown for illustration only. As mentioned above, further components can be optionally included in optical pickup 20.

Optionally, an apparatus according to an embodiment of the invention, also includes an analog-to-digital (A/D)-converter 90 for converting a voltage provided by terminal 10 to a digital signal. For instance, a digital signal can be provided to a bus 95, which is capable of distributing the digital signal to internal and external processing units, including but not limited to output devices, memory devices and control circuitry.

A further constitutional element that is, although not mandatory, present in most optical disk drives, is laser modulator 45. Laser modulator 45 serves for modulating the laser at a high frequency (in a range of approximately 300 - 500MHz, for instance 400MHz).

Laser modulator 45 is a circuit directly at the laser and switches the laser on and off with the indicated high frequency. After being switched off for a short period of time, the laser diode adjusts to a new oscillation mode upon being switched on again. Thereby the Reflected Intensity Noise is reduced that can be present due to backward reflection from the optical disk into the laser. Consequently, the performance is improved.

An example of laser light output intensity modulated with a frequency of 400MHz is illustrated in the insert of Fig. 1.

An effect that generally affects the precision of temperature measurement with the monitor diode is the so-called "crosstalk" effect. "Crosstalk" means an influence of an additional current component induced in monitor diode 4 by the photoelectric effect during temperature measurement. The additional current component is however small, since the monitor diode is driven in forward mode during temperature sensing (while it is in reverse mode during the light sensing function). The influence of crosstalk is taken into account for determination of temperature, in a preferred embodiment.

The crosstalk due to the laser light depends on the constant current of the monitor diode in the temperature measurement mode. Increasing of monitor current decreases the crosstalk. For a predetermined temperature sensing current of, for instance, 2mA, the influence of the crosstalk is slightly smaller than 0.5K (the temperature seems to decrease by approximately 0.5K, if the laser is switched on). A large forward current in the monitor diode however leads to self-heating of the monitor diode. Therefore, the power consumption of the monitor diode shall be limited to approximately 1-2% of the power of the laser diode. In case of 2mA * 731 mV = 1.468mW it is less than 1% of the heating through the laser diode (2.4V * 70mA - 6.3mW = 161.7mW; only 6.3mW is optical output power of the laser, the rest is converted to heat).

An exemplary estimation of crosstalk influence on temperature is shown in Table 1 below, for constant forward current intensity values of 0.5mA, 1mA and 2mA. Further, the following assumptions are made for the examples of Table 1:

Used Laser (Red for DVD): wavelength: 632nm; voltage: 2.4V; driving current 70mA; laser output power 6.3mW. Further, in compliance with experimental studies, the dependency between forward voltage and temperature of the monitor diode is assumed to be in accordance with a coefficient of -2mV/K.

A correction for crosstalk can be easily performed by adding an offset to the sensed temperature according to the table.

TABLE 1

| Constant Current through the Monitor Diode | Voltage at Monitor Diode Laser OFF Laser OFF | Voltage at Monitor Diode Laser ON Laser ON | Delta Monitor Voltage = Crosstalk | Delta Temperature = Impact of Laser Light on Temp. Measurement |
|---|---|---|---|---|
| 0.5 mA | 663 mV | 669 mV | 6 mV | 3 K |
| 1 mA | 697 mV | 699 mV | 2 mV | 1 K |
| 2 mA | 731 mV | 732 mV | 1 mV | 0.5 K |

As confirmed by the exemplary values in the table, the crosstalk due to laser light (conversion photons=>electrons in the pn junction) is not very high.

Alternatively, the influence of crosstalk can be eliminated by synchronizing switching means 30 with the laser modulation voltage of approximately 300-500MHz provided by laser modulator 45. While laser diode 2 is in the "switched off" phase, no crosstalk to the laser diode is possible. Therefore, the short period of time during which the laser is switched off, can be used to read out the temperature without crosstalk, if switching means 30 is synchronized with laser modulator 45. The optional feature of synchronizing laser modulator 45 with switching means 30 is indicated by the dashed line labeled "SYNC" in Fig. 1.

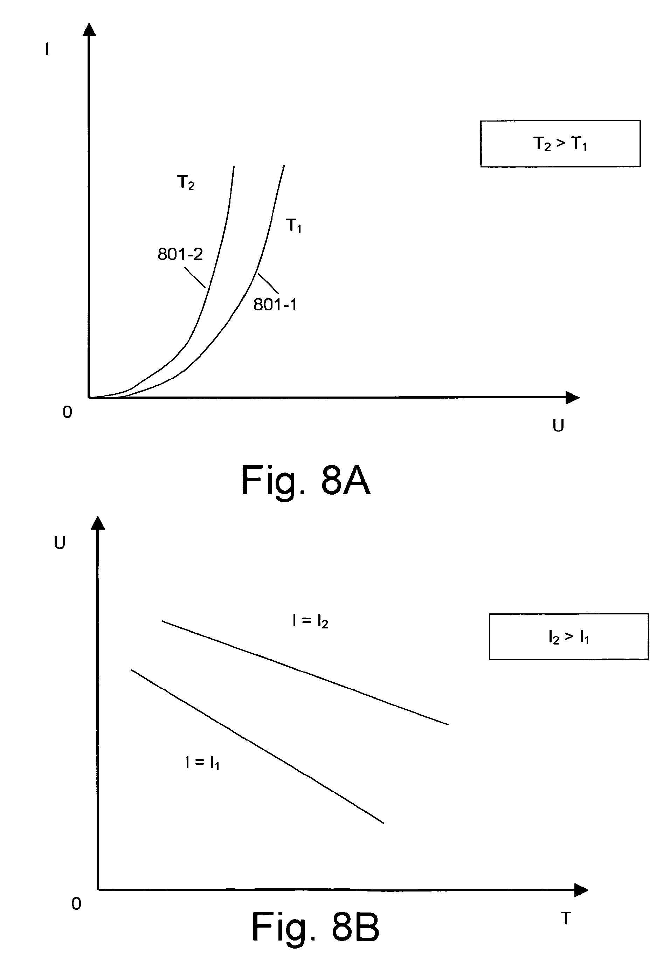

Figs. 8A and 8B illustrate the current-voltage characteristic of the pn-junction of a diode, corresponding to a current flowing in a forward direction, and the characteristic temperature dependency thereof.

As illustrated in Fig. 8A, forward current I of a diode generally exponentially increases with forward voltage U. However, the slope of the exponential function is not constant, but depends on temperature. Curves 801-1 and 801-2 illustrate I-U- curves for different temperatures. Curve 801-1 corresponds to a temperature $T_1$, and curve 801-2 corresponds to a temperature $T_2$, so that $T_2 > T_1$. As can be seen from the figure, forward current I increases faster with increasing forward voltage U, if the temperature becomes higher. On the other hand, the result is a smaller voltage drop at a predetermined constant forward current intensity, for a higher temperature, as illustrated in Fig. 8B.

Fig. 8B illustrates how forward voltage U depends on temperature T, for a constant forward current I. As can be seen from Fig. 8B, there is a linear dependency between voltage drop and temperature for a given current. Fig. 8B illustrates curves of the voltage-temperature dependency for two predetermined constant current intensities, $I = I_1$ and $I = I_2$, so that $I_2 > I_1$ Although the voltage at the pn-junction for a given current generally tends to decrease with increasing temperature, it is moreover shown that the slope of the decrease decreases with increasing current. Accordingly, for a larger current such as $I_2$ in Fig. 8B, the voltage-temperature characteristic is less steep than for lower current $I_1$.

Since the particular manner in which the slope of the voltage-temperature characteristic depends on the current intensity is universal, i.e. caused by the physical nature of a diode, but does not depend on the particular kind of diode used, in principle, the temperature can be very precisely determined by measuring voltages $U_2$ and $U_1$ for two given predetermined currents $I_2$ and $I_1$ at one and the same temperature to be determined. The respective formula for determining the temperature is given by

$$T = (U_2 - U_1) / (C \ln(I_2/I_1)). \qquad (1)$$

In equation (1), C represents a constant C = k/q, wherein k is Boltzmann's constant, and q is the charge of an electron, i.e. C is a universal physical constant.

On the other hand, temperature determination based on a single constant current flow is possible, if a respective calibration has been performed in advance. Therefore, the parameters of the linear function representing the U-T characteristic of the particular diode for the given current, i.e. the slope and an offset value (constant term) have to be determined.

Sample values of the U-T characteristic can be pre-stored in a memory. Alternatively, slope and offset of the linear function can be stored and provided to a processor for determining a temperature corresponding to a voltage signal detected at terminal 10. Preferably, calibration is performed at the time of manufacturing the device including the monitor diode.

For determining a temperature based on subsequent measurements with two different currents, a current ratio of about 10:1 is typically used. Before forwarding the resulting voltage values $U_1$ and $U_2$ to a processing means, temperature evaluation can be performed based on the universal formula given by equation (1).

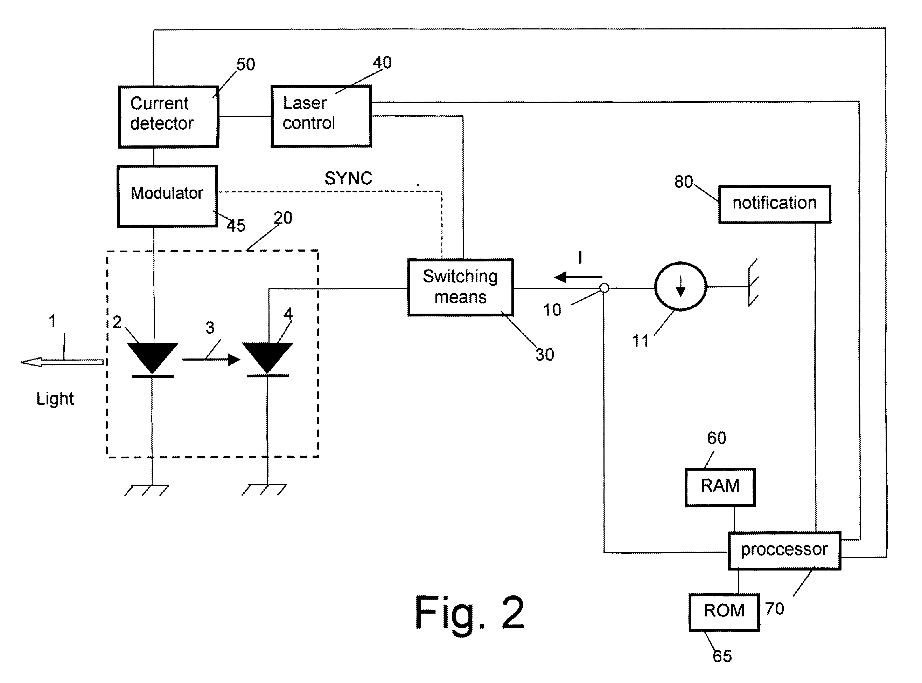

A more particular example of an optical reproducing/recording apparatus is illustrated in Fig. 2. In addition to both components that are illustrated in Fig. 1, the detailed description of which will therefore not be repeated in the following, the diagram of Fig 2 further illustrates the inclusion of a current detector 50 for detecting a driving current flowing through laser diode 2 controlled by laser control circuitry 40. As outlined above, the driving current flowing through a laser diode for achieving a predetermined controlled laser power output depends on both the operating temperature and the degree of deterioration of the laser diode, due to processes that are inherent in increasing operating time. Therefore, current detection, employed together with temperature sensing according to the present invention can be easily employed to precisely estimate a degree of deterioration of the laser diode, and accordingly determine whether an expiry of the lifetime of the laser diode has to be expected.

As illustrated in Fig. 2, the laser current is preferably measured at the anode side of the laser diode 2. In case if laser modulator 45 is additionally included, laser current has to be measured (via the voltage drop over a resistor) between laser control circuitry 40 and laser modulator 45, i.e. not directly at the anode.

An illustration of the temperature dependency of the driving current has been illustrated in Fig. 3 and is described above in connection with Fig. 3. Fig. 5 illustrates how the dependency between output power and driving current intensity for a constant temperature T = const. varies with an increasing operation time of the laser diode. The figure illustrates graphs indicating $P_{out}$ - I - characteristics for one and the same temperature, but corresponding to three different values ($t = t_a$, $t = t_b$ and $t = t_c$, so that $t_c > t_b > t_a$) of the overall operation time the laser diode has been in use. As can be generally seen from Fig. 5, the laser diode deteriorates over time, and after being used for longer than a certain period of time, it fails to provide the required light output ($t = t_c$). Specifically, a driving current I required to obtain an identical light output Pout tends to rise with an increase in the amount of overall operation time t, and the light output shows a tendency to sharply drop when a certain driving current is exceeded.

As can be seen from Fig. 5 (compare, for instance, the curves corresponding to operation time instances $t = t_a$ and $t = t_b$), during an extended range of operation times, the driving current required to provide a specified light output (for instance, a laser power of 20mW) rises with an increase in the overall operation time (accumulated current supply time). It is known that the driving current increases in proportion to the square root of the current supply time. Accordingly, at the beginning of operation of the laser diode, the driving current increase of a APC-controlled laser diode is rather slow. On the other hand, after the slowly increasing driving current has been increased by a certain amount over a reference value corresponding to the driving current intensity required for the controlled laser output power at the beginning of operation, i.e. for the new laser diode, the light output sharply drops. Such a situation is illustrated in Fig. 5, by the rightmost curve corresponding to timing $t = t_c$. For commercially available diodes that are used in practice, such a situation occurs when an electric driving current required for a predetermined output power reaches a value that is approximately 10 to 30% higher than the corresponding initial value. The overall current supply time, $t_c$, corresponding to the situation described, depends on the kind of diode, and the particular operation conditions. As a rule, the overall operation time until the output power sharply drops is in the range of at least several thousands of hours. Since a normal operation of the laser diode is no longer possible after the situation corresponding to $t = t_c$ in Fig. 5 has been reached, it has to be considered that $t = t_c$ corresponds to a situation wherein the lifetime of the laser diode has expired. In other words, the operation of the laser diode starts at t = 0, and time instance $t = t_c$ corresponds to the overall lifetime of the laser diode. In order to detect expiry of the lifetime of the laser diode, driving current determined by current detector 50 has therefore to be compared with a predetermined deterioration threshold current $I_d$. In correspondence with the characteristic data given above, a deterioration threshold current $I_d$ can be set to, for instance, 1.1 times to 1.3 times the initial reference current, corresponding to a threshold being 10% to 30% higher than the initial value. However, the invention is not limited to these values, but other values also possible, under certain conditions.

If the current flowing through the laser diode is detected to be greater than the deterioration current threshold $I_d$, it shall be determined that operation time of the laser diode has expired.

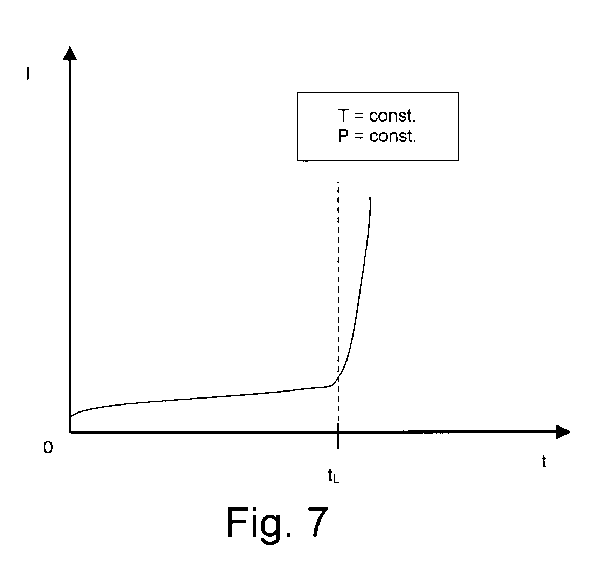

The apparatus illustrated in Fig. 2 further includes processor 70 for evaluating the detected current. An alternative illustration of the dependency of the driving current on the accumulated operation time is illustrated in Fig. 7. Fig. 7 schematically illustrates a graphical dependency of driving current I upon operation time t, under the assumption that the parameters laser output power Pout and temperature T are assumed to be constant. As can be seen from Fig. 7, the strength of the input current starts to slowly increase with operation time (according to a square root law). After a certain amount of operation time has been accumulated, a driving current I required to obtain an identical light output $P_{out}$ tends to rise drastically with a further increase in the amount t of the accumulated operation time. Such a change in the behaviour of the laser diode can be seen at the instance of time labeled $t_L$ in the graph of Fig. 7, which corresponds to the "kink" of the illustrated curve. Therefore, it is assumed that $t_L$ approximately corresponds to the lifetime of the laser diode.

For evaluating an increase in the driving current for determining expiry of the lifetime of the laser diode, however, the temperature dependency has to be additionally taken into account. Since an increasing temperature also tends to lead to an increasing driving current required for the same light output power, in order to safely determine the expiry of lifetime, the influence of the temperature must therefore be carefully considered and separated from the influence of the deterioration over time.

An alternative illustration of the driving current dependence on temperature, to achieve a predetermined output power $P_{out}$ = const. is illustrated in Fig. 6. Generally, the input driving current rises with increasing temperature according to a linear function. The slope of the linear function depends on the particular laser diode used. An exemplary illustration for two different laser diodes, LD1, and LD2, is shown in Fig. 6.

Therefore, an optical disc drive according to the present invention additionally employs the concept of temperature determination, based on the pn-junction of the monitor diode, as illustrated above in connection with Fig. 1. An output voltage that is provided at terminal 10 during a period of time wherein switching means 30 have connected a terminal of laser diode 4 to current source 11, is further forwarded to processor 70. Although not illustrated in Fig. 2, in a preferred embodiment the apparatus includes A/D-converter 90, and provides the output voltage data to the processor as digital data.

As further described above, processor 70 may associate a particular voltage output by terminal 10 with a temperature, based on a lookup table for pre-stored parameters of a linear dependency such as is illustrated in Fig. 8B. Therefore, Fig. 2 further illustrates that memory units such as RAM (random access memory) 60 and ROM (read only memory) 65 are provided. Preferably, also an erasable non-volatile memory, such as EEPROM (electrically erasable programmable read only memory) or FEPROM (flash erasable programmable read only memory) are provided. Each of the mentioned memory devices may serve as a first memory or a second memory or a third memory as defined in the appended claims, with the exemption that the third memory cannot be realized as a ROM, since writing access during the operation of the apparatus is required. It is further noted that separate hardware units may be foreseen for the first, the second and the third memory, respectively, but also separately addressable sections of a single memory unit may be issued for that purpose. It is further noted that the type of memory units mentioned above is not essential for the present invention, and the invention is not limited to these. Other memory units, such as hard disc drive, etc. are possible.

As indicated above, a memory unit generally pre-stores at least a single default input current for a desired laser output power. The pre-stored default current corresponds to the input current which is desired for a certain output power at a particular temperature, at the beginning of the life cycle of the laser diode. Preferably, such parameters are determined upon manufacturing the apparatus including the laser diode, before commercial operation starts. A coefficient for calculating a default current value corresponding to a particular temperature determined by monitor diode 4 provided via terminal 10 can then be calculated by processor 70, if necessary. Details of possible embodiments performing temperature correction will be described below.

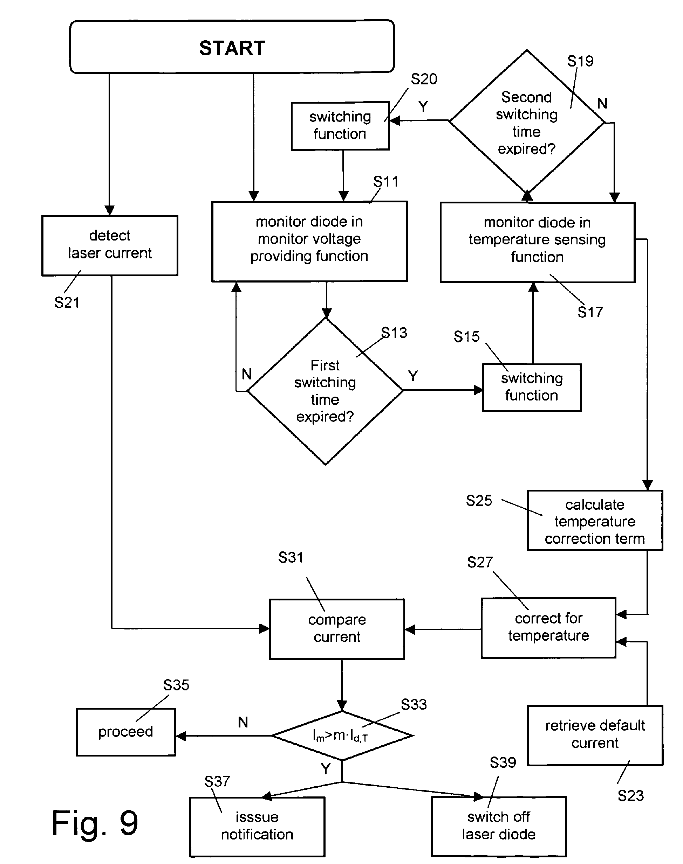

Alternatively, a look-up table including several pairs of values of driving currents, together with the corresponding operation temperatures at the beginning of the life cycle of the laser diode may be pre-stored. In view of the linearity of the underlying functional dependency, the values not included in the look-up table may be calculated by processor 70 by performing a linear interpolation, if desired by the required precision. Details of the processing steps performed by processor 70 will be further explained below in connection with the operation flow chart of Fig. 9. Generally speaking, processor 70 compares an input current that is permanently monitored by current detector 50 with the default input current value corresponding to the temperature detected by monitor diode 4. If the monitored current detected by current detector 50 at a certain instance of time significantly exceeds the respective default current corresponding to the respective temperature, i.e. the driving current corresponding to the controlled laser output power and temperature at the beginning of the life cycle of the laser diode, the processor determines expiry of lifetime of the laser diode. More specifically, it is determined by processor 70 that the lifetime of the laser diode expires, if a currently monitored input current is larger than the respective default current by the predetermined percentage, or, alternatively, by a predetermined amount. The respective condition is preset, preferably at the time of manufacture, and applied by the processor. When processor 70 determines expiry of lifetime of the laser diode, a respective notification is issued. As already explained above, notification may include an acoustic signal or an optical signal indicated on a display (not shown). The term of a notification also includes predetermined data to be stored in a memory, in order to be read out by an external device that can be connected to the apparatus, such as the computer of a service technician. In particular, for optical disc drives applied in an environment where regular monitoring by service staff is available, the respective data can be retrieved, without interfering with the user.

Moreover, it may also be advantageous if the processor stops the operation of the laser diode, when a significant increase of driving current is detected. At the same time, the respective notification can also be issued. Accordingly, the user is informed that the optical pickup shall be replaced, immediately before the recording and reproduction of data becomes unavailable. Therefore, erroneous reading/recording can be prevented.

Fig. 4 is a more detailed illustration of a particular embodiment of an apparatus according to the present invention. Specifically, while other optional components have been omitted, a diagram of Fig. 4 illustrates in more detail exemplary embodiments of switching means 30 and laser control circuitry 40.

As can be seen from Fig. 4, switching means 30 of the illustrated preferred embodiment include multiplexer 12 and pulse generator 13. As illustrated, multiplexer 12 serves to achieve switchover between the temperature sensing function and the laser control function of the monitor diode. In the upper switching position (i.e. the position illustrated in the drawing), the temperature sensing function is selected. Therefore, monitor diode 4 is connected to current source 11 so that a predetermined current can flow through monitor diode 4 in a forward direction. In the alternative position (lower position of multiplexer 12, not illustrated), monitor diode 4 will be connected to the laser power control circuitry. Multiplexer 12 is controlled by pulse generator 13. While a short electric pulse output by pulse generator 13 is "on", multiplexer 12 is switched to the upper position. During the remaining time, no pulse is available (in other words: the pulse is in the "off" state), and multiplexer 12 is switched to the lower connection state corresponding to the laser power control function.

In the illustrated preferred embodiment, laser power control circuitry 40 includes a potentiometer 5, a capacitor 6, a reference voltage source 7 and a laser power controller 8, including a comparator. A monitor voltage provided by converting a monitor current from monitor diode 4 (possibly after amplification by an amplifier, not shown) into a monitor voltage in potentiometer 5 is input to an input port of laser power controller 8.

Upon comparing the monitor voltage with a reference level indicating a desired light output, the driving current of the laser diode 2 is adjusted. Therefore, upon manufacturing, potentiometer 5 is adjusted to control the laser to provide a desired laser output power, while the reference voltage 7 has a predetermined value. In an alternative embodiment (not illustrated), a simple resistor is provided instead of potentiometer 5. Control of desired of laser power is then performed by varying reference value 7 in the APC. Capacitor 6 serves to keep the monitor voltage during the period of time wherein the laser power control circuitry is disconnected from the monitor diode by multiplexer 12, for performing the temperature sensing function. Pulse times are switched to the multiplexer 12 in the upper position of Fig. 4 should therefore be short enough for capacitor 6 to hold the monitor voltage. Optionally, a sample and hold circuit (illustrated by means of dashed box 14 in Fig. 4) is provided for loading capacitor 6 via a buffer and thus independently of the potentiometer adjustment.

A general scheme of a sample and hold circuit 14 as applicable for an apparatus according to the present invention is illustrated in Fig. 11. Sample and hold circuit 14 includes, besides capacitor 6, also impedance converter 141, switch 142 and voltage follower (buffer) 143. When switch 142 is in the "on"-state, capacitor 6 is loaded via impedance converter 141. Impedance converter 141 serves for quickly loading capacitor 6 by means of providing a high intensity current, such that an influence on the voltage source is minimal, and the measurement result is affected as little as possible. Voltage follower (buffer) 143 serves for holding the output voltage as long as possible, even when switch 142 is in the "off"-state. The resistance of switch 142 in the "off"-state must therefore be large. As illustrated in Fig. 11, impedance converter 141 and voltage follower 143 are preferably realized by means of operational amplifiers.

Optionally, a synchronization is provided between laser modulator 45 and pulse generator 13, in order to enable crosstalk free temperature sensing, as indicated by dashed line "SYNC" in Fig. 4.

An exemplary embodiment of a method for estimating lifetime of a laser diode including a method of determining the temperature of an optical pickup device in accordance with the present invention will now be described in connection with Fig. 9.

The processing of Fig. 9 starts with step S11, wherein the monitor diode performs the monitor voltage providing function described above (i.e. multiplexer 12 of Fig. 4 is switched into the lower position, connecting photodiode 4 with the laser power control circuitry). In the embodiments illustrated in Fig. 9, monitor diode 4 is periodically switched between the monitor voltage providing function and the temperature sensing function, in such a way that the monitor diode 4 remains in the monitor voltage providing function for a first predetermined period of time, and remains in the temperature sensing function for a second predetermined period of time. Accordingly, the monitor diode 4 remains in the monitor voltage providing function as long as the first predetermined period of time has not yet expired (S13: N). As soon as the first predetermined period of time expires (S13: Y), switching means 30 switches the function of the monitor diode into the temperature sensing function (step S15). In the particular embodiment of Fig. 4, the situation corresponds to the time period, wherein the pulse signal of pulse generator 13 is "on", and multiplexer 12 is switched into the upper position, connecting the terminal of monitor diode 4 to current source 11. Accordingly, monitor diode 4 remains in temperature sensing function (step S17), as long as the second predetermined period of time has not yet expired (S19: N). As soon as the second predetermined period of time has expired (S19: Y) switching means 30 switches the monitor diode back to the monitor voltage providing function (step S20).

In the following, an embodiment of a method for estimating expiry of lifetime of laser diode 2 employing the temperature sensing function of monitor diode 4 according to the present invention is described. In parallel to the above described monitor diode switching functions, the input current flowing through laser diode 2 is permanently monitored (step S21). In step S23, a pre-stored default input current is retrieved. In the present embodiment, a single default current $I_d$ has been pre-stored. The single pre-stored default current $I_d$ corresponds to an input current necessary for achieving the desired laser output power at a predetermined default temperature $T_d$ (for instance: room temperature of 20°C). Default input current $I_d$ is determined at the beginning of the lifecycle of the laser diode. In step S25, the current operation temperature as sensed by monitor diode 4 in step S17 is retrieved, and a temperature correction is calculated by processor 70.

The temperature correction term is determined in accordance with the particular input current-temperature dependency for laser diode 2 that has been determined at the beginning of the lifecycle of the laser diode, as illustrated in Fig. 6. The calculated temperature correction term allows the determination of the default current intensity required to flow through the non-deteriorated laser diode, in order to achieve the desired output power, at the currently sensed operation temperature. Accordingly, the correction term is calculated as $K(T-T_d)$, wherein T is the sensed current operation temperature, and K is a constant representing the slope the curve of Fig. 6 for the particular laser diode. The constant coefficient K is predetermined at the time of manufacture of the laser diode, and pre-stored in a memory. In order to determine coefficient K, the input current of the laser diode in order to determine the desired laser output power is determined for two different operation temperature values, $T_1$ and $T_2$ (preferably the first temperature value, $T_1$, is equal to default temperature $T_d$). The constant coefficient K, representing the slope of the graph of Fig. 6 is then calculated according to equation

$$K = (I_{T2} - I_{T1}) / (T_2 - T_1). \qquad (2)$$

In subsequent step S27, a temperature corrected default input current $I_{d,T}$ is determined by adding the temperature correcting term calculated in step S25 to the default input current retrieved in step S23:

$$I_{d,T} = I_d + K(T - T_d). \qquad (3)$$

In subsequent Step S31, the laser input current detected in step S21, and the temperature corrected default current determined in step S27 are compared with each other. In the following, step S33 determines whether the monitored current $I_m$ of step S21 exceeds a temperature corrected default current $I_{d,T}$ significantly. In the illustrated embodiment, it is specifically determined whether $I_m$ is larger than $I_{d,T}$ multiplied by a constant factor m (for instance: m = 1.2 corresponding to an excess value of 20%, but, as indicated above, a person skilled in the art will appreciate that other values of m are equally applicable in the present invention). As long as the condition of step S33 is not fulfilled (S33: N), it is determined that deterioration of laser diode 2 has not yet reached the degree corresponding to the expiry of the lifetime of the laser diode, and operation of the optical reproducing/recording apparatus proceeds as usual (step S35). If, to the contrary, monitored laser current $I_m$ increases to such an extent that the condition set forth in step S33 becomes fulfilled (S33: Y), it is determined that the lifetime of laser diode 2 expires. Consequently, a notification is issued (step S37). As described above, a notification may include an acoustic as well as an optical warning, and also a signal bit to be stored in a memory unit for being read out by a service technician. At the same time, processor 70 switches off laser diode 2 (step S39). Therefore, any improper operation of the optical disc drive due to the high degree of deterioration of the laser diode can be safely avoided.

A person skilled in the art will appreciate that the particular embodiment of a method for estimating life time of a laser diode in an optical reproducing/recording apparatus according to the present invention is given herein by example only. A plurality of modifications of a method employing temperature sensing function by a monitor diode according to the present invention are possible. For instance, in step S33, a determination can be performed whether monitored current $I_m$ exceeds temperature corrected default current $I_{d,T}$ by a predetermined offset value to be added, instead of the predetermined multiplication factor m. Also, it would be possible to temperature correct the monitored current output by step S21, instead of the default current retrieved in step S23. Therefor, the temperature correction term calculated in step S25 should be subtracted from the monitoring result of step S21.

A person skilled in the art will further appreciate that a plurality of further modifications is possible within the scope of the present invention, as defined by the appended claims. As indicated above, the temperature sensing function in an optical recording/reproducing apparatus according to the present invention is not limited to the purpose of lifetime estimation of the laser diode. To the contrary, a method and apparatus according to the present invention can be employed for various purposes as a simple, reliable and precise means to determine an operation temperature of an optical pickup device, and thus to improve reproducing/recording quality.

As indicated above, together with the necessary driving current to achieve a particular laser light output power of a laser diode, the expected lifetime of the laser diode tends to decrease with an increasing operation temperature, as well. Therefore, on the one hand, sufficient ventilation of the optical pickup device is always required in order to increase durability of the laser diode. On the other hand, a lifetime estimation method based on the present invention, which is generally less precise than the one described above, but very simple is also possible. Namely, while monitor diode 4 is switched to the temperature sensing function from time to time, an operation temperature is detected each time (i.e. a kind of a "stroboscopic" measurement). The determined operation temperature values are accumulated in a memory, and the accumulated value is regularly read out and compared with a predefined maximum value. When the accumulated value exceeds the predetermined maximum value it is determined that lifetime of the laser diode has expired, and a respective notification is issued and/or operation is inhibited.

In order to determine the accumulated value to be stored in the memory, it is preferred that the temperature values sensed by monitor diode 4 and output by terminal 10 are not directly stored in an accumulation register. Instead, processor 70 preferably determines a weighted value indicating an extent, by which the detected operation temperature value decreases the expected lifetime, as compared with a standard temperature such as 20°C.

In summary, the invention relates to a very precise temperature sensing function of an optical pickup in an optical reproducing/recording apparatus such as an optical disc drive with a small hardware effort. Rather than including dedicated hardware components for temperature sensing, such as PTC elements in the apparatus, a monitor diode (photodetector) employed for automatic laser power control is additionally employed as temperature sensor. Due to direct thermal coupling between laser diode and monitor diode, the operation temperature of the laser diode itself can be precisely determined. Therefore, the present invention is particularly suitable for lifetime estimation of the laser diode.

## Claims

1. An optical reproducing/recording apparatus, comprising:

   a laser diode (2) for providing a laser light beam (1) for reading or recording information on an optical storage medium,
   laser control circuitry (40) for adjusting laser power of said laser diode (2), and
   a monitor diode (4) for sensing a light output (3) of said laser diode (2) and providing a monitor voltage to said laser control circuitry (40), as a feedback based on the sensed light output (3);

   **characterized in that**

   said monitor diode (4) being connectable for further providing a voltage indicating a temperature, based on a predetermined current (I) flowing through said monitor diode (4).

2. An optical reproducing/recording apparatus according to claim 1, wherein said voltage indicating the temperature based on a known temperature dependency of the current-voltage characteristic (801-1, 801-2) of the pn-junction of the monitor diode (4).

3. An optical reproducing/recording apparatus according to claim 2, further comprising a first memory (60) for pre-storing a look-up table, said look-up table including temperature values in association with voltage values indicating the temperature values, for said predetermined current (I) and said monitor diode (4).

4. An optical reproducing/recording apparatus according to any of claims 1 to 3, further comprising a current source (11) for providing said predetermined current (I).

5. An optical reproducing/recording apparatus according to any of claims 1 to 4, wherein said predetermined current (I) is a constant current.

6. An optical reproducing/recording apparatus according to any of claims 1 to 5, wherein said voltage indicating a temperature having a linear dependency on the temperature of said monitor diode (4).

7. An optical reproducing/recording apparatus according to any of claims 1 to 6, further comprising switching means (30) for switching said monitor diode (4) between a monitor voltage providing function and a temperature sensing function.

8. An optical reproducing/recording apparatus according to claims 2 and 7, wherein said switching means (30) switching a terminal of said monitor diode (4) between said current source (11) and said laser control circuitry (40).

9. An optical reproducing/recording apparatus according to claim 7 or 8, wherein said temperature sensed by said monitor diode (4) in said temperature sensing function is corrected for crosstalk between said laser diode (2) and said monitor diode (4) due to laser induced current generated in said monitor diode during the temperature sensing function.

10. An optical reproducing/recording apparatus according to any of claims 1 to 9, wherein said laser control circuitry (40) comprising

> a laser power controller (8) with a reference voltage (7),
> a potentiometer (5) for laser power adjustment, and
> a capacitor (6).

11. An optical reproducing/recording apparatus according to claim 10, wherein said capacitor (6) being capable of holding the monitor voltage during a period of switching the monitor diode (4) to said temperature sensing function.

12. An optical reproducing/recording apparatus according to claim 10, further comprising a sample and hold circuitry (14) for loading said capacitor (6).

13. An optical reproducing/recording apparatus according to any of claims 10 to 12, wherein said laser power controller (8) being integrated with said reference voltage (7) in a large scale integration.

14. An optical reproducing/recording apparatus according to claim 12 and 13, wherein said large scale integration further including an impedance converter (141), a switch (142) and a voltage follower (143) included in said sample and hold circuitry (14).

15. An optical reproducing/recording apparatus according to any of claims 7 to 14, wherein said switching means (30) comprising a multiplexer (12).

16. An optical reproducing/recording apparatus according to claim 15, further comprising a pulse generator (13) for controlling said multiplexer (12).

17. An optical reproducing/recording apparatus according to any of claims 1 to 16, further comprising a laser modulator (45) for periodically switching said laser diode (2) on and off at a high frequency.

18. An optical recording/reproducing apparatus according to claims 7 and 17, wherein said switching means (30) being synchronized with said laser modulator (45), such that the monitor diode (4) is switched to said temperature sensing function during a period, wherein said laser diode (2) is switched off.

19. An optical reproducing/recording apparatus according to claims 2, 13 and 16, wherein said large scale integration further including said current source (11), said multiplexer (12) and said pulse generator (13).

20. An optical reproducing/recording apparatus according to any of claims 1 to 19, wherein said laser diode (2) and said monitor diode (4) are arranged in close proximity with each other.

21. An optical reproducing/recording apparatus according to claim 20, wherein said laser diode (2) and said monitor diode (4) are arranged in an optical pickup device (20).

22. An optical reproducing/recording apparatus according to claims 7 and 21, wherein said optical pickup device (20) further including at least one of said switching means (30) and said laser control circuitry (40).

23. An optical reproducing/recording apparatus according to claim 21 or 22, wherein said laser diode (2) and said monitor diode (4) being mounted in a common cabinet.

24. An optical reproducing/recording apparatus according to any of claims 1 to 23, further comprising a current detector (50) for monitoring an intensity of an input current of said laser diode (2), in correspondence with the respective laser light output.

25. An optical reproducing/recording apparatus according to claim 24, further comprising a processing means (70) for estimating deterioration of said laser diode (2) based on said monitored input current intensity and said indicated temperature.

26. An optical reproducing/recording apparatus according to claim 25, wherein said processing means (70) comparing said monitored input current intensity with a default input current intensity corresponding to the respective laser light output, taking into account said indicated temperature.

27. An optical reproducing/recording apparatus according to claim 26, further comprising a second memory (60, 65) for storing said default input current intensity.

28. An optical reproducing/recording apparatus according to claim 27, wherein said default input current intensity being stored at the time of manufacturing.

29. An optical reproducing/recording apparatus according to claim 27 or 28, wherein said second memory (60, 65) storing a lookup table including default input current intensity values for a plurality of temperature values.

30. An optical reproducing/recording apparatus according to claim 27 or 28, wherein
said second memory (60, 65) storing a single default input current intensity value, and
said processing means (70) being further adapted to calculate a temperature correction term for taking into account said indicated temperature in comparing said monitored input current intensity and said default input current intensity.

31. An optical reproducing/recording apparatus according to claim 30, wherein said processing means (70) determining a temperature corrected default input current intensity by applying said calculated temperature correction term to said stored default input current intensity, and comparing said monitored input current intensity with said temperature corrected default input current intensity.

32. An optical reproducing/recording apparatus according to claim 30, wherein said processing means (70) temperature correcting said monitored input current intensity by applying said temperature correction term to said monitored input current intensity, and comparing the monitored input current intensity, after temperature correction, with the stored single default input current intensity value.

33. An optical reproducing/recording apparatus according to any of claims 26 to 32, wherein said processing means (70) determining a degree of deterioration indicating expiry of lifetime of said laser diode (2), if said comparison results in that said monitored input current intensity is significantly larger that said default input current intensity.

34. An optical reproducing/recording apparatus according to claim 33, wherein said processing means (70) determining said degree of deterioration of said laser diode (2), if said monitored input current intensity exceeds said default input current intensity by a predetermined amount.

35. An optical reproducing/recording apparatus according to claim 33, wherein said processing means (70) determining said degree of deterioration of said laser diode (2), if said monitored input current intensity exceeds said default input current intensity by a predetermined percentage.

36. An optical reproducing/recording apparatus according to any of claims 33 to 35, further comprising notification means (80) for issuing a notification signal, if said processing means (70) determining a degree of deterioration indicating expiry of lifetime of said laser diode (2).

37. An optical reproducing/recording apparatus according to claim 36, further comprising a third memory (60) for storing said notification signal, in order to be read out by an external device.

38. An optical reproducing/recording apparatus according to claim 36 or 37, wherein said notification signal including an acoustic or optical warning.

39. An optical reproducing/recording apparatus according to any of claims 33 to 38, wherein said processing means (70) being adapted to automatically switch off said laser diode (3), upon determining a degree of deterioration indicating expiry of lifetime of said laser diode (2).

40. An optical reproducing/recording apparatus according to any of claims 1 to 39, further comprising an analog/digital converter (90) for converting said voltage indicating a temperature into a digital signal, and a bus system (95) for providing said digital signal indicating the temperature.

41. An optical reproducing/recording apparatus according to any of claims 21 to 40, wherein said optical pickup device (20) further including a memory unit, wherein said memory unit being adapted to function as at least one of said first, said second or said third memory.

42. A vehicle entertainment and information device comprising an optical reproducing/recording apparatus according to any of claims 1 to 41.

43. A method of determining a temperature in an optical reproducing/recording apparatus, the optical reproducing/ recording apparatus including a laser diode (2) for providing a laser light beam (1) for reading or recording information on an optical storage medium, laser control circuitry (40) for adjusting laser power of said laser diode (2), and a monitor diode (4) for sensing a light output (3) of said laser diode (2) and providing a monitor voltage to said laser control circuitry (40), as a feedback based on the sensed light output (3), the method **characterized by** the step of:

connecting (S20) said monitor diode (4) for providing (S17) a voltage indicating a temperature, based on a predetermined current (I) flowing through said monitor diode (4).

44. A method according to claim 43, wherein said voltage indicating the temperature based on a known temperature dependency of the current-voltage characteristic (801-1, 801-2) of the pn-junction of the monitor diode (4).

45. A method according to claim 44, further comprising the step of pre-storing a look-up table, said look-up table including temperature values in association with voltage values indicating the temperature values, for said predetermined current (I) and said monitor diode (4).

46. A method according to any of claims 43 to 45, wherein said connecting step (S20) connecting said monitor diode (4) to a current source (11) for providing said predetermined current (I).

47. A method according to any of claims 43 to 46, wherein said predetermined current (I) is a constant current.

48. A method according to any of claims 43 to 47, wherein said voltage indicating a temperature depending on the temperature of said monitor diode (4) in a linear manner.

49. A method according to any of claims 43 to 48, further comprising the step of switching (S15, S20) said monitor diode (4) between a monitor voltage providing function (S11) and a temperature sensing function (S17).

50. A method according to claim 49, wherein said switching step (S15, S20) switching a terminal of said monitor diode (4) between said current source (11) and said laser control circuitry (40).

51. A method according to claim 49 or 50, further comprising the step of correcting the temperature sensed by said monitor diode (4) in said temperature sensing function (S17) for crosstalk between said laser diode (2) and said monitor diode (4) due to laser induced current generated in said monitor diode during the temperature sensing function.

52. A method according to any of claims 49 to 51, further comprising the step of holding the monitor voltage during a period wherein the monitor diode (4) is switched (S15) to said temperature sensing function (S17).

53. A method according to any of claims 43 to 52, wherein said laser diode (2) and said monitor diode (4) are arranged in close proximity with each other.

54. A method according to claim 53, wherein said laser diode (2) and said monitor diode (4) are arranged in an optical pickup device (20).

55. A method according to claim 53 or 54, wherein said laser diode (2) and said monitor diode (4) being mounted in a common cabinet.

56. A method according to any of claims 43 to 55, further comprising the step of monitoring (S21) an intensity of an input current of said laser diode (2), in correspondence with the respective laser light output.

57. A method according to claim 56, further comprising the step of estimating (S31, S33) deterioration of said laser diode (2) based on said monitored input current intensity and said indicated temperature.

**58.** A method according to claim 57, wherein said estimating step including the step of comparing (S31) said monitored input current intensity with a default input current intensity corresponding to the respective laser light output, taking into account said indicated temperature.

**59.** A method according to claim 58, further comprising the step of pre-storing said default input current intensity.

**60.** A method according to claim 59, wherein said default input current intensity being pre-stored at the time of manufacturing said optical reproducing/recording apparatus.

**61.** A method according to claim 59 or 60, wherein said step of pre-storing said default input current intensity storing a lookup table including default input current intensity values for a plurality of temperature values.

**62.** A method according to claim 59 or 60, wherein
said step of pre-storing said default input current intensity storing a single default input current intensity value, and the method further comprises the step of
calculating (S25) a temperature correction term for taking into account said indicated temperature in comparing said monitored input current intensity and said default input current intensity.

**63.** A method according to claim 62, further comprising the step of determining (S27) a temperature corrected default input current intensity by applying said calculated temperature correction term to said stored default input current intensity, wherein said comparing step (S31) comparing said monitored input current intensity with said temperature corrected default input current intensity.

**64.** A method according to claim 63, further comprising the step of temperature correcting (S27) said monitored input current intensity by applying said temperature correction term to said monitored input current intensity, wherein said comparing step (S31) comparing the monitored input current intensity, after temperature correction, with the stored single default input current intensity value.

**65.** A method according to any of claims 58 to 64, wherein said estimating step (S31, S33) determining a degree of deterioration indicating expiry of lifetime of said laser diode (2), if said comparing step (S31) determines that said monitored input current intensity is significantly larger that said default input current intensity.

**66.** A method according to claim 65, wherein said estimating step (S31, S33) determining said degree of deterioration of said laser diode (2), if said comparing (S31) determines that said monitored input current intensity exceeds said default input current intensity by a predetermined amount.

**67.** A method according to claim 66, wherein said estimating step (S31, S33) determining said degree of deterioration of said laser diode (2), if said comparing step (S31) determines that said monitored input current intensity exceeds said default input current intensity by a predetermined percentage (S33:Y).

**68.** A method according to any of claims 65 to 67, further comprising the step of issuing (S37) a notification signal, if said estimating step (S31, S33) determining a degree of deterioration indicating expiry of lifetime of said laser diode (2).

**69.** A method according to claim 68, further comprising the steps of
storing said notification signal in a memory, in said optical reproducing/recording apparatus, and
reading out said notification signal, by an external device.

**70.** A method according to claim 68 or 69, wherein said notification signal including an acoustic or optical warning.

**71.** A method according to any of claims 65 to 70, further comprising the step of automatically switching off (S39) said laser diode (2), when said estimating step (S31, S33) determining a degree of deterioration indicating expiry of lifetime of said laser diode (2).

**72.** A method according to any of claims 43 to 71, further comprising the step of analog/digital converting said voltage indicating a temperature into a digital signal, and providing said digital signal indicating the temperature via a bus system (95).

**73.** A method according to any of claims 54 to 72, wherein said optical pickup (20) further comprising a memory unit for storing default characteristics of said laser diode and said monitor diode.

Fig. 1

Light
400MHz

Light

A/D

95

90

10

11

1

I

Switching means

30

SYNC

20

Laser control

40

Modulator

45

2

3

4

Fig. 2

# Fig. 3

# Fig. 4

Fig. 5

Fig. 6

**Fig. 7**

Fig. 8A

Fig. 8B

Fig. 9

# Fig. 10
(Prior art)

# Fig. 11

**European Patent Office**

**EUROPEAN SEARCH REPORT**

Application Number

EP 07 02 4246

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2001 216672 A (YAMAHA CORP) 10 August 2001 (2001-08-10) | 1-6,10, 13,14, 19-23, 43-48, 53-55, 72,73 | INV. G11B7/125 H01S5/026 ADD. H01S5/068 |
| Y | * the whole document * | 24-39, 56-71 | |
| | ----- | | |
| X | EP 1 750 335 A (SHINKO ELECTRIC IND CO [JP]) 7 February 2007 (2007-02-07) | 1,2, 4-17, 19-23, 40-44, 46-55, 72,73 | |
| Y | * the whole document * | 24-39, 56-71 | |
| | ----- | | |
| X | US 4 930 134 A (MACAIONE ANTHONY F [US] ET AL) 29 May 1990 (1990-05-29) | 1,2,4,5, 7,8,10, 13-23, 40-44, 46-50, 52-55, 72,73 | TECHNICAL FIELDS SEARCHED (IPC) G11B H01S |
| Y | * the whole document * | 24-39, 56-71 | |
| | ----- | | |
| Y | EP 0 512 541 A (FUJITSU LTD [JP] FUJITSU LTD [DE]) 11 November 1992 (1992-11-11) * the whole document * | 24-39, 56-71 | |
| | ----- | | |

The present search report has been drawn up for all claims

| Place of search | Date of completion of the search | Examiner |
|---|---|---|
| The Hague | 13 February 2008 | Demoor, Kristoffel |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT**

**ON EUROPEAN PATENT APPLICATION NO.**                    EP 07 02 4246

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2008

| Patent document cited in search report | | Publication date | Patent family member(s) | | Publication date |
|---|---|---|---|---|---|
| JP 2001216672 | A | 10-08-2001 | NONE | | |
| EP 1750335 | A | 07-02-2007 | JP | 2007042839 A | 15-02-2007 |
| | | | US | 2007030868 A1 | 08-02-2007 |
| US 4930134 | A | 29-05-1990 | CA | 2033329 A1 | 06-12-1990 |
| | | | EP | 0427849 A1 | 22-05-1991 |
| | | | JP | 4501193 T | 27-02-1992 |
| | | | WO | 9015459 A1 | 13-12-1990 |
| EP 0512541 | A | 11-11-1992 | DE | 69213811 D1 | 24-10-1996 |
| | | | DE | 69213811 T2 | 30-01-1997 |
| | | | DE | 69230734 D1 | 06-04-2000 |
| | | | DE | 69230734 T2 | 29-06-2000 |
| | | | JP | 2546080 B2 | 23-10-1996 |
| | | | JP | 4334078 A | 20-11-1992 |
| | | | US | 5334826 A | 02-08-1994 |

EPO FORM P0459

For more details about this annex : see Official Journal of the European Patent Office, No. 12/82